(19) **Europäisches Patentamt**
**European Patent Office**
**Office européen des brevets**

(11) **EP 4 003 688 B1**

(12) **EUROPEAN PATENT SPECIFICATION**

(45) Date of publication and mention
of the grant of the patent:
**10.05.2023   Bulletin 2023/19**

(21) Application number: **20743695.7**

(22) Date of filing: **23.07.2020**

(51) International Patent Classification (IPC):
**B29C 45/76** (2006.01)      **B29C 45/00** (2006.01)

(52) Cooperative Patent Classification (CPC):
**B29C 45/0005; B29C 45/76; B29C 45/7693**

(86) International application number:
**PCT/EP2020/070858**

(87) International publication number:
**WO 2021/013958 (28.01.2021 Gazette 2021/04)**

(54) **COMPUTER-IMPLEMENTED METHOD FOR SIMULATING A FILLING PROCESS OF A MOLD CAVITY**

SIMULATION EINER FLÜSSIGKEITSTRÖMUNG IN SPRITZGIESSEN

SIMULATION D'UN ÉCOULEMENT DE FLUIDE DANS LE MOULAGE PAR  INJECTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.07.2019   EP 19188138**

(43) Date of publication of application:
**01.06.2022   Bulletin 2022/22**

(73) Proprietor: **BASF SE**
**67056 Ludwigshafen am Rhein (DE)**

(72) Inventors:
• **GLASER, Stefan**
**67056 Ludwigshafen (DE)**

• **WONISCH, Andreas**
**67056 Ludwigshafen (DE)**

(74) Representative: **BASF IP Association**
**BASF SE**
**GBI-C006**
**67056 Ludwigshafen (DE)**

(56) References cited:
**EP-A2- 1 376 415          EP-B1- 2 612 266
US-A1- 2008 221 845     US-B1- 9 862 133
US-B1- 9 919 465**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 003 688 B1

**Description**

Technical Field

The invention relates to a computer-implemented method for simulating a filling process of a mold cavity in an injection molding process, a method for verifying a design of an object, a computer system, a computer program and a database for use in the computer-implemented method. Such methods, systems and devices can, in general, be employed for technical design or configuration purposes e.g. in a development phase of an injection molding process. However, further applications are possible.

Background art

Injection molding processes are common manufacturing processes in recent small and large scale manufacturing industry. In typical injection molding processes plastic material, such as thermoplastic, thermosetting or elastomer material, is melted, usually in a heating process, and then injected into an empty die, e.g. under an applied pressure. The plastic material is then hardened, usually in a cooling or curing process, in order to remain in the form given by the die, thereby becoming the manufactured product. It allows reproduction of the products formed by the die in large quantities. Due to high costs for designing and configuring the die, the die cannot be easily modified if any problems occur during injection molding. Thus, in order to minimize production costs and waste, the filling process of the die or mold cavity is typically simulated before using common simulation methods.

Various methods for simulating a filling process of a mold cavity in an injection molding process are known. However, generally the performing of such methods is very time-consuming and complex. In particular, such methods typically require the performance of complex calculations, e.g. numerical solving of complex systems of differential equations. Thus, such methods in general require large storage and computation capacities.

For reducing the time and resources necessary for generating a set of injection mold simulation results, as an example, EP 2 612 266 B1 describes methods, systems, and apparatus, including computer programs encoded on a computer storage medium, for interactively simulating an injection mold model. A three-dimensional CAD model is identified representing an injection mold cavity. The mold cavity includes a location of at least one gate. A potential fill pattern is determined for injection of a material into the injection mold cavity. The determined fill pattern is based at least in part on the geometry and dimensions of the modeled mold cavity and the location of the at least one gate. A strip model of the CAD model is generated based at least in part on the determined fill pattern. The strip model is used to perform a strip analysis simulating injection of the material within the injection mold cavity.

Further, as an example, EP 1376415 A2 describes a method for modeling injection of a fluid into a mold defining a three dimensional cavity. The method comprises: providing a three dimensional computer model defining the cavity; discretizing a solution domain based on the model; specifying boundary conditions; and solving for process variables using conservation of mass, conservation of momentum, and conservation of energy equations for at least a portion of the solution domain. The step of discretizing a solution may comprise generating a finite element mesh based on the model by subdividing the model into a plurality of connected elements defined by a plurality of nodes; and anisotropically refining the mesh such that there are more nodes in a first direction of greater variation of material properties than in a second direction of lesser variation of material properties, the refinement comprising at least one of the substeps of calculating a distance from a node to a boundary; and using a node layer numbering system.

Further, US 9919465 B1 describes a molding system including a mold having a mold cavity; a molding machine configured to fill the mold cavity with a composite molding resin including a polymeric material having a plurality of fibers; a computing apparatus connected to the molding machine; and a controller connected to the computing apparatus. The computing apparatus includes a processor configured to generate a previous orientation distribution of the fibers in the mold cavity based on a molding condition for the molding machine, a rotary diffusional distribution of the fibers based on the previous orientation distribution of the fibers, and an updated orientation distribution of the fibers based on the rotary diffusional distribution of the fibers. The controller is configured to control the molding machine to perform an actual molding with the molding condition for injecting the composite molding resin into at least a portion of the mold cavity.

Furthermore, US 2008/221845 A1 describes an apparatus and methods for performing process simulation and structural analysis using a hybrid model. For example, a method of the invention automatically defines a hybrid solution domain by dividing a representation of a plastic component or mold cavity into two portions-a portion in which a simplified analysis may be conducted, and a portion in which a more complex analysis is required. The method may use as input any form of CAD data that describes the surface of a component or mold. Furthermore, the invention provides methods for simulating fluid flow within a mold cavity by automatically creating a hybrid solution domain, automatically discretizing the domain, and solving for the distribution of process variables within the solution domain.

US 9862133 B1 describes a method for preparing an injection-molded fiber-reinforced composite article using a molding machine controlled by a controlling module connected to the molding machine. The method performs a molding simulation executed on the controlling module to generate a shear rate distribution of the composite molding resin in a simulating domain. Subsequently, the method generates an orientation distribution of the fibers in the composite molding resin executed on the controlling module by taking into consideration an effect of the shear rate on an inter-fiber interaction and/or an effect of the shear rate on reducing a response rate of the fibers. A controller then controls the molding machine with the molding condition to perform an actual molding for injecting the composite molding resin into at least a portion of the mold cavity.

Despite the advantages involved in recent injection molding process simulation methods, several technical challenges remain. Thus, still, simulating the filling process may be very time-consuming and complex, and required computation capacities may still be excessively high. Further, in addition to fill patterns and manufacturability, properties of the produced product may need to be considered.

Problem to be solved

It is therefore desirable to provide means and methods which address the above mentioned technical challenges of simulating a filling process of a mold cavity in an injection molding process. Specifically, methods, systems, programs and databases shall be proposed for further improving the performance of simulating a filling process of a mold cavity in an injection molding process, compared to devices, methods and systems known in the art.

Summary

This problem is addressed by the methods, systems, programs and databases with the features of the independent claims. Advantageous embodiments which might be realized in an isolated fashion or in any arbitrary combinations are listed in the dependent claims.

As used in the following, the terms "have", "comprise" or "include" or any arbitrary grammatical variations thereof are used in a non-exclusive way. Thus, these terms may both refer to a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

Further, it shall be noted that the terms "at least one", "one or more" or similar expressions indicating that a feature or element may be present once or more than once typically will be used only once when introducing the respective feature or element. In the following, in most cases, when referring to the respective feature or element, the expressions "at least one" or "one or more" will not be repeated, non-withstanding the fact that the respective feature or element may be present once or more than once.

Further, as used in the following, the terms "preferably", "more preferably", "particularly", "more particularly", "specifically", "more specifically" or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in such way with other optional or non-optional features of the invention.

In a first aspect of the invention a computer-implemented method for simulating a filling process of a mold cavity in an injection molding process using a plastic material is disclosed. The computer-implemented method may also be referred to as method or simulation method. The computer-implemented method comprises the following steps, which may be performed in the given order. However, a different order may also be possible. Further, one or more than one or even all of the steps may be performed once or repeatedly. Further, the method steps may be performed in a timely overlapping fashion or even in parallel. The method may further comprise additional method steps which are not listed.

The computer-implemented method comprises the following steps:

    i) discretizing at least a part of the mold cavity into a plurality of cells;
    ii) defining a cavity injection point;
    iii) determining a surface normal direction perpendicular to the nearest cavity surface for each cell;
    iv) determining a cell coordinate system for each cell, defined by

    -    a first principal direction parallel to a flow direction,
    -    a third principal direction parallel to the normal direction, and

- a second principal direction perpendicular to the first and third principal directions; and

v) determining the flow direction of a mold flow for each cell.

The term "filling process" as used herein is a broad term and is to be given its ordinary and customary meaning to a person of ordinary skill in the art and is not to be limited to a special or customized meaning. The term specifically may refer, without limitation, to a procedure of pouring, pressing or sucking at least one material, specifically a formless material, such as a liquid or molten material, into an arbitrary collector or containment, such as a mold. Thus, the term "filling process of a mold cavity" may refer to a procedure of filling a formless material, such as a fluid or a molten mass of material, into an arbitrary void of a die or form. In particular, the mold cavity, e.g. the void of the die or form, may be configured for transferring a shape or form onto the formless material. In particular, a "filling process of a mold cavity in an injection molding process" may be a procedure of filling a formless material, such as a fluid or molten mass of material, into a mold cavity, for example into the void of the die or form, by way of injection, specifically by applying pressure on the formless material. Specifically, for the formless mass, a molten mass of the plastic material may be used.

The term "plastic material" as used herein is a broad term and is to be given its ordinary and customary meaning to a person of ordinary skill in the art and is not to be limited to a special or customized meaning. The term specifically may refer, without limitation, to an arbitrary thermoplastic, thermosetting or elastomer material. In particular, the plastic material may be a mixture of substances comprising monomers and/or polymers. Specifically, the plastic material may be or may comprise a thermoplastic material. Additionally or alternatively, the plastic material may be or may comprise a thermosetting material. Additionally or alternatively, the plastic material may comprise an elastomer material.

The plastic material may comprise further substances, such as filling materials, for example dispersed within the plastic material. In particular, the further substances may for example be one or more of an arbitrary fiber, such as at least one reinforcement fiber. Specifically, the plastic material may be a fiber-reinforced plastic material. As an example, the fibers dispersed within the plastic material may be fibers having a length L with $0 \text{ mm} < L \leq 50 \text{ mm}$, specifically $0 \text{ mm} < L \leq 10 \text{ mm}$, more specifically $0.05 \text{ mm} \leq L \leq 1 \text{ mm}$.

The term "discretizing" as used herein is a broad term and is to be given its ordinary and customary meaning to a person of ordinary skill in the art and is not to be limited to a special or customized meaning. The term specifically may refer, without limitation, to the process of dividing an arbitrary predefined space, such as a two- or three-dimensional form, into a finite number of entities or subspaces. In particular, the at least part of the mold cavity may be discretized into a plurality of cells.

The term "cell" as used herein is a broad term and is to be given its ordinary and customary meaning to a person of ordinary skill in the art and is not to be limited to a special or customized meaning. The term specifically may refer, without limitation, to an arbitrary shaped entity or space, specifically a subspace. The cell may have a surface consisting of a plurality of flat surfaces, wherein each of the plurality of flat surfaces may simultaneously form a flat surface of at least one adjacent or neighboring cell. Specifically, the cell may have a tetrahedral, cuboid or octahedral shape or form. A cell form with curved edges is also possible. As an example, all the cells of the plurality of cells may equal each other in at least one property of the cell, such as a volume, form or shape of the cell. Thus, as an example, at least part of the mold cavity may be discretized into a plurality of cells having tetrahedral form.

The term "cavity injection point" as used herein is a broad term and is to be given its ordinary and customary meaning to a person of ordinary skill in the art and is not to be limited to a special or customized meaning. The term specifically may refer, without limitation, to a location of an entrance through which the material enters the cavity in a filling process. In particular, the cavity injection point may be or may comprise a location of at least one hole in a cavity wall of the mold cavity through which the formless material, e.g. a molten mass of the plastic material, may be injected into the mold cavity. Specifically, a flow of the material, e.g. of the plastic material, into the mold cavity may start at the cavity injection point.

The term "surface normal direction" as used herein is a broad term and is to be given its ordinary and customary meaning to a person of ordinary skill in the art and is not to be limited to a special or customized meaning. The term specifically may refer, without limitation, to a course parallel to a straight line, wherein the line is orthogonal to a surface. In particular, the surface normal direction determined for each cell in step iii) may be the surface normal direction of the nearest cavity surface. Specifically, for each cell of the plurality of cells, the surface normal direction perpendicular to the nearest cavity surface may be determined. Thus, for each cell, a normal direction for the cell may be determined which is perpendicular to the surface of the mold cavity closest to the cell.

A cell coordinate system, as determined in step iv), may be assigned to each of the cells of the plurality of cells. The term "cell coordinate system" as used herein is a broad term and is to be given its ordinary and customary meaning to a person of ordinary skill in the art and is not to be limited to a special or customized meaning. The term specifically may refer, without limitation, to a Cartesian coordinate system assigned to the cell. Thus, the cell coordinate system may be a Cartesian coordinate system comprising three principal directions aligned at right angles to each other, wherein the first principle direction is parallel to a flow direction, specifically to a flow direction of the cell, the third principle direction in parallel to a normal direction, specifically to the normal direction for the cell, more specifically to the normal direction for the nearest surface or surface cell of the cell, and the second principle direction is perpendicular to the first and third principle directions.

The term "flow direction" as used herein is a broad term and is to be given its ordinary and customary meaning to a person of ordinary skill in the art and is not to be limited to a special or customized meaning. The term specifically may refer, without limitation, to a line or course on which an arbitrary material is moving or is aimed to move. In particular, the flow direction may refer to the local direction in which the molten mass of plastic material is moving, for example in the filling process. The flow direction specifically may refer to the local direction of the average mass flow of the molten mass of plastic material, e.g. in the filling process. Thus, the first principal direction of the cell coordinate system may be parallel to the direction in which the molten mass of plastic is moving within or through the cell. In particular, the first principal direction of the cell coordinate system may be parallel to the initial direction in which the molten mass of plastic is moving within or through the cell when first entering the cell, specifically in the filling pro.

If the plastic material is a fiber-reinforced plastic material, the method may further comprise the following step: vi) determining fiber orientation of the fiber-reinforced plastic material.

The term "fiber orientation" as used herein is a broad term and is to be given its ordinary and customary meaning to a person of ordinary skill in the art and is not to be limited to a special or customized meaning. The term specifically may refer, without limitation, to at least one item of information describing the spatial orientation of a fiber in space. Thus, as an example, the fiber orientation may comprise at least one angle describing the orientation of a fiber axis of the fiber with respect to at least one coordinate system or angular coordinate system. Additionally or alternatively, the at least one item of information may comprise a vector, such as a unit vector, oriented parallel to the fiber axis of the fiber.

In particular, step vi) may further comprise evaluating the plastic material to be used in the injection molding process and, in case the plastic material used in the injection molding process is a fiber reinforced plastic material, determining the fiber orientation of the fiber-reinforced plastic material.

Step vi) may further comprise substep vi.1) of providing a database. In particular, the database may contain information on fiber orientation for the fiber-reinforced plastic material for at least one dummy element.

The term "database" as used herein is a broad term and is to be given its ordinary and customary meaning to a person of ordinary skill in the art and is not to be limited to a special or customized meaning. The term specifically may refer, without limitation, to an arbitrary collection of information, such as information stored in at least one data storage device. The data base may also comprise the at least one data storage device with the information stored therein. In particular, the database may contain an arbitrary collection of information. As an example, the database may comprise information on fiber orientation for the fiber reinforced plastic material.

The term "dummy element" as used herein is a broad term and is to be given its ordinary and customary meaning to a person of ordinary skill in the art and is not to be limited to a special or customized meaning. The term specifically may refer, without limitation, to an arbitrary object used for analyzing or testing. In particular, the dummy element may be created or manufactured for at least the purpose of analyzing or determining properties of the dummy element. Specifically, the dummy element may be configured for providing information, e.g. information on at least one property of the dummy element. The dummy element may for example comprise at least one fiber-reinforced plastic material and may be configured for providing information on fiber-orientation, specifically information on fiber-orientation within the dummy element. The information on fiber orientation within the dummy element may be stored in the database.

The information contained in the database may for example comprise one or both of simulated data or empirically retrieved data on fiber orientation. Specifically, the information contained in the database may comprise empirically retrieved data, such as data retrieved by using at least one dummy element, on fiber orientation. Additionally or alternatively, the database may comprise simulated data on fiber orientation, such as, for example, data on fiber orientation retrieved by using one or more simulation tools known to the person skilled in the art, such as simulation tools based on finite element method (FEM) simulations.

Step vi) may further comprise substep vi.2) of retrieving information on fiber orientation for each cell from the database by using a cell position of the cell and determining fiber orientation for the cell in the cell coordinate system.

The database may be organized such that the information on fiber orientation for each cell may be retrievable or accessible via information on the cells position. Specifically, the database may be structured such that information on the cell position may be linked to information on fiber orientation.

The cell position may for example comprise at least one distance selected from the group consisting of:

- a distance of the cell from a central plane of the mold cavity;
- a distance of the cell from a central axis of the mold cavity;
- a distance of the cell from the nearest cavity surface; and
- a distance of the cell from the cavity injection point.

The distance may be given in relative units and/or absolute units. Thus, the distance may be given in relative distance units such as for example in a number of cells. As an example, the distance may be given in a number of cells from the central plane of the mold cavity, from the central axis of the mold cavity, from the nearest cavity surface and/or from the cavity injection point.

Step vi.2) may in particular be performed by using similarity considerations between the mold cavity and the dummy element. Specifically, step vi.2) may be performed by using similarity considerations between a shape of the mold cavity and a shape of the dummy element.

The term "similarity consideration" as used herein is a broad term and is to be given its ordinary and customary meaning to a person of ordinary skill in the art and is not to be limited to a special or customized meaning. The term specifically may refer, without limitation, to a regard or assessment of an arbitrary resemblance or correspondence between at least two subjects. Thereby, as an example, by similarity considerations, properties of a known object may be transferred onto an unknown object. In particular, a similarity, for example a resemblance or correspondence, may be considered between two subjects, such as between the mold cavity and the dummy element. Specifically, the similarity between the at least two subjects, e.g. between the mold cavity and the dummy element, may be considered by comparing at least one property of each of the at least two subjects, such as a shape, form, expanse or the like.

In particular, the similarity considerations may be based on the assumption that, by using similar definitions of coordinate systems for the cell of the mold cavity and for the dummy element, the fiber orientation in the mold cavity is identical to the fiber orientation in the dummy element for identical relative positions within the mold cavity and the dummy element, respectively.

The method may further comprise determining surface cells of the plurality of cells. In particular, the method may comprise determining surface cells of the plurality of cells before performing step iii) of the method. Specifically, the method may comprise determining surface cells of the plurality of cells between steps i) and ii) of the method.

The term "surface cell" as used herein is a broad term and is to be given its ordinary and customary meaning to a person of ordinary skill in the art and is not to be limited to a special or customized meaning. The term specifically may refer, without limitation, to an arbitrary cell located or arranged at an outermost part of an arbitrary object. In particular, the surface cell may be located at an outer boundary of a shape or form of an arbitrary object. Thus, as an example, a surface cell of the plurality of cells discretizing the mold cavity may for example be located at a surface of the mold cavity. Specifically, the surface cells of the plurality of cells discretizing the mold cavity may comprise an arbitrary number of cells located at the surface of the mold cavity.

The method may further comprise determining neighboring cells for each individual cell of the plurality of cells. Specifically, the method may comprise determining neighboring cells of the plurality of cells before performing step v) of the method. More specifically, the method may comprise determining neighboring cells for each individual cell of the plurality of cells between steps i) and iii) of the method.

The term "neighboring cell" as used herein is a broad term and is to be given its ordinary and customary meaning to a person of ordinary skill in the art and is not to be limited to a special or customized meaning. The term specifically may refer, without limitation, to an arbitrary adjoining or adjacent cell. In particular, the neighboring cell to an individual cell of the plurality of cells may be a cell located adjacent from the individual cell. Specifically, each individual cell of the plurality of cells may have a plurality of neighboring cells.

The method may further comprise determining a cell-filling sequence using information on the neighboring cells. In particular, information on the neighboring cells gathered by determining the neighboring cells for each individual cell of the plurality of cells may be used for determining the cell-filling sequence. In particular, the cell-filling sequence may start with a starting cell, wherein the starting cell is located at the cavity injection point.

The method may further comprise a recursive determination of an inflow of a molten mass of the plastic material from neighboring cells for each individual cell. Thus, in particular, for each individual cell of the plurality of cells, the inflow of the molten mass of the plastic material from its neighboring cells may be determined recursively. As an example, balances of masses or mass flow may be calculated iteratively.

Further, the method may comprise recursively solving a continuity equation for each individual cell by considering inflow from neighboring cells and outflow into neighboring cells. Specifically, for each individual cell of the plurality of cells a continuity equation may be solved recursively, for example, by considering the inflow from its neighboring cells and the outflow into its neighboring cells. The term "continuity equation" as used herein is a broad term and is to be given its ordinary and customary meaning to a person of ordinary skill in the art and is not to be limited to a special or customized meaning. The term specifically may refer, without limitation, to an equation or formula describing a transport of an arbitrary quantity. In particular, the continuity equation may be based on the physics principle of conservation. Specifically, the continuity equation may be based on the principle of mass conservation. The continuity equation may thus consider a mass balance. For example, in the continuity equation it may be considered that for any cell, an outflow of the molten mass of plastic material into neighboring cells equals an inflow into the cell from neighboring cells minus the molten mass of plastic material remaining in the cell itself.

The method may further comprise determining a wall thickness information for each of the cells of the plurality of cells. Specifically, the method may comprise determining a wall thickness before performing step v). More specifically, the method may comprise determining a wall thickness between steps iv) and v). The term "wall thickness", specifically the term "wall thickness information", as used herein is a broad term and is to be given its ordinary and customary meaning to a person of ordinary skill in the art and is not to be limited to a special or customized meaning. The term specifically may refer, without limitation, to a local extension of an arbitrary element in a normal direction of the surface of the element. Specifically, the wall thickness of the mold cavity may be or may comprise information on an extension of the mold cavity in a normal direction of the surface of the mold cavity. Additionally or alternatively, the wall thickness of the mold cavity may be or may comprise information on an extension of the mold cavity in a direction perpendicular to a flow direction, specifically to a flow direction of a molten mass of plastic material in the filling process of the mold cavity. For example, the wall thickness information for a cell of a plurality of the cells, specifically of a plurality of cells discretizing the mold cavity, may be an extension of the cell in a normal direction of the surface of the mold cavity. Additionally or alternatively, the wall thickness information for a cell of a plurality of cells, specifically of a plurality of cells discretizing the mold cavity, may be an extension of the cell in a direction perpendicular to the flow direction, in particular perpendicular to the flow direction of the molten mass of plastic material. As an example, the wall thickness information for a cell of a plurality of cells may be an extension in a normal direction of the surface of the mold cavity, wherein the extension is further oriented perpendicular to the flow direction of the molten mass of plastic material.

The method may further comprise determining a flow front advance. In particular, a progress or advance of a flow front of the molten mass of the plastic material may be determined. Specifically, an advance of the flow front of the molten mass of the plastic material within the mold cavity may be determined. The term "flow front" as used herein is a broad term and is to be given its ordinary and customary meaning to a person of ordinary skill in the art and is not to be limited to a special or customized meaning. The term specifically may refer, without limitation, to a forefront of moving or advancing fluid or molten material. In particular, the flow front may be or may comprise the forefront of the molten mass of plastic material advancing within the mold cavity, for example in the filling process. The term "flow front advance" as used herein is a broad term and is to be given its ordinary and customary meaning to a person of ordinary skill in the art and is not to be limited to a special or customized meaning. The term specifically may refer, without limitation, to a progress of the flow front. In particular, the flow front advance may be or may comprise a progress in a forward travelling of the flow front, such as a progress of the forefront of the moving or advancing molten mass of plastic material within the mold cavity in the filling process.

The step of determining the flow front advance may specifically comprise determining a flow front velocity. As an example, the flow front velocity may be calculated using the following formulas:

$$v = \frac{h^2}{12\,\eta} \cdot \frac{p_1 - p_0}{l}, \text{ and} \qquad (1)$$

$$Q = v \cdot A = \text{const}, \qquad (2)$$

wherein h may denote the wall thickness for the cell. In particular, the wall thickness may for example be or may comprise a distance between corresponding surface cells or elements on for example an upper and a lower side of the mold cavity, specifically in a normal direction of the surface cells. Specifically, $\eta$ may denote a viscosity of a molten mass of the plastic material. In particular, $p_1$ may denote a filling pressure of the molten mass of the plastic material and $p_0$ may denote an ambient pressure in the mold cavity. For example, I may denote a distance of the flow front from the cavity injection point. Q may denote a volume flow rate of the plastic material. A may denote a filled surface area, specifically a surface area filled with the plastic material. It may specifically be assumed that a pressure at the flow front equals an ambient pressure in the mold cavity. Thus, the ambient pressure $p_0$ in the mold cavity may be presumed to equal a local pressure within the mold cavity at the flow front of the molten mass of the plastic material.

If a determined pressure level is higher than a predetermined pressure threshold, the flow front advance may stop. Thus, the progress of the flow front may terminate, in case the determined pressure level, for example a calculated pressure level, exceeds the predetermined pressure threshold. The predetermined pressure threshold may for example resemble a maximum pressure, specifically a maximum achievable value of a pressure, acting on the molten mass of the plastic material during the injection molding process.

The determined pressure level may depend on one or more of a property of the molten mass of the plastic material used in the injection molding process and a mold geometry. Specifically, the determined pressure level may depend on one or more of the property of the molten mass of the plastic material used in the injection molding process, for example the at least one viscosity of the molten mass of the plastic material, and the mold geometry, such as the at least one wall thickness or at least one flow path length.

The method may further comprise determining a minimum pressure demand for completely filling the mold cavity with the molten mass of the plastic material. For example, in case the plastic material is a fiber reinforced plastic material, the method may comprise determining a minimum pressure demand for completely filling the mold cavity with the fiber reinforced plastic material. Specifically, determining the minimum pressure demand may be or may comprise identifying a smallest pressure value suitable for filling the mold cavity completely with the molten mass of the plastic material.

The information contained in the database may for example comprise data on fiber orientation in at least one dummy element having a predetermined thickness. In particular, the fiber orientation may be given in the database as a function of a position within the dummy element.

The information on fiber orientation may be given in the database as a function of at least one distance selected from the group consisting of:

- a distance from a central plane of the dummy element;
- a distance from a central axis of the dummy element;
- a distance from the nearest cavity surface of the dummy element; and
- a distance from an injection point of the dummy element.

The distance may for example be given in relative units. Thus, the distance may be given in relative distance units such as for example in a number of cells. As an example, the distance may be given in a number of cells from the central plane of the dummy element, from the central axis of the dummy element, from the nearest cavity surface of the dummy element and/or from the injection point of the dummy element.

The information on fiber orientation may specifically contain at least one of a direction of fiber orientation and a degree of fiber orientation. In particular, the information on fiber orientation may contain one or more of the direction of fiber orientation and the degree of fiber orientation, specifically a degree of fiber orientation in each principal direction.

Further, the information on fiber orientation may contain a direction of fiber orientation in a dummy coordinate system of the dummy element. As an example, the dummy coordinate system may be defined by:

- a first principal direction parallel to a flow direction in the dummy element, specifically to a central axis of the dummy element;
- a third principal direction perpendicular to a surface of the dummy element, specifically perpendicular to a surface of a slab-shaped dummy element or to a plane of extension of the slab-shaped dummy element; and
- a second principal direction perpendicular to the first and third principal directions.

The at least one dummy element may specifically comprise at least one slab-shaped element having at least two parallel surfaces. In particular, at least a part of the dummy element may have a flat shape, for example a plate or slice shape, such as a flat rectangular shape. Specifically, the slab-shaped element may have a rectangular cross-section, with a width exceeding a thickness. In particular, the slab shaped element may have a rectangular cross section, with the width exceeding the thickness by at least a factor of two. More specifically, the slab shaped element may have a rectangular cross section, with the width exceeding the thickness by at least a factor of three or at least a factor of four.

The database may specifically contain information on fiber orientation for a plurality of fiber-reinforced plastic materials. Thus, the database may contain information on fiber orientation for at least two, preferably more than two, fiber reinforced plastic materials. Further, the database may contain information on fiber orientation for a plurality of fiber-reinforced plastic materials for identical dummy elements.

The method may further comprise determining weld line cells of the plurality of cells, wherein at least two flow fronts meet in each of the weld line cells.

Information on a fiber orientation in the weld line cells may for example be retrieved from the database provided in step vi.1) of the method.

The method may further comprise determining one or more of a filling pressure, a flow path length, a shear rate, a shrinkage and a critical thickness for each cell, specifically a mass accumulation.

As an example, performing at least steps i) to v) of the method may take a processing time T, wherein $0\ s < T \leq 300\ s$, specifically $0\ s < T \leq 120\ s$, more specifically $0\ s < T \leq 60\ s$, particularly $0\ s < T \leq 30\ s$.

The method may further comprise:

vii) outputting at least one visualization selected from the group consisting of: a fiber orientation, specifically a direction of fiber orientation; a degree of fiber orientation, specifically a degree of fiber orientation in at least one principal direction; a filling state, specifically a filling state after a predetermined amount of time; a pressure state, specifically a pressure state after a predetermined amount of time; a shear rate distribution, specifically a shear rate distribution state after a predetermined amount of time; a mass accumulations state; a flow path length state; a shrinkage state.

In particular, the visualization may be output via at least one interface or port. The term "interface" as used herein is a broad term and is to be given its ordinary and customary meaning to a person of ordinary skill in the art and is not to be limited to a special or customized meaning. The term specifically may refer, without limitation, to an item or element forming a boundary configured for transferring information. In particular, the interface may be configured for transferring information from a computational device, e.g. a computer, such as to send or output information, e.g. onto another device. Additionally or alternatively, the interface may be configured for transferring information onto a computational device, e.g. onto a computer, such as to receive information. The interface or port may specifically provide means for transferring or exchanging information. In particular, the interface may provide a data transfer connection, e.g. Bluetooth, NFC, inductive coupling or the like. As an example, the interface or port may be or may comprise one or more of a network or internet port, a USB-port and a disk drive. The visualization may also be displayed on a visual display.

In a further aspect of the invention, a method for verifying a design of an object is disclosed. The method may also be referred to as verification method. The method comprises the following steps, which may be performed in the given order. However, a different order may also be possible. Further, one or more than one or even all of the steps may be performed once or repeatedly. Further, the method steps may be performed in a timely overlapping fashion or even in parallel. The method may further comprise additional method steps which are not listed.

The method comprises the following steps:

I. providing CAD data of the object;
II. transforming the CAD data of the object into CAD data of a corresponding mold cavity for injection molding the object;
III. choosing at least one plastic material and at least one injection point;
IV. simulating a filling process of the mold cavity by using the method, specifically the simulation method, as described above or as described in further detail below; and
V. evaluating a simulation result provided by step IV.

The term "design" as used herein is a broad term and is to be given its ordinary and customary meaning to a person of ordinary skill in the art and is not to be limited to a special or customized meaning. The term specifically may refer, without limitation, to a plan and/or specification of an object or process. The design, as an example, may comprise the shape of the object and/or other technical details rendered in the plan.

The term "verifying" as used herein is a broad term and is to be given its ordinary and customary meaning to a person of ordinary skill in the art and is not to be limited to a special or customized meaning. The term specifically may refer, without limitation, to a process of one or more of reviewing, inspecting or testing a product or a process for compliance with one or more prerequisites or standards, such as in order to establish and document that a product, service or system meets regulatory or technical standards. Specifically, the verification of a design may comprise evaluating, e.g. by simulation and/or testing, if the design is suitable for the intended use, such as if the design of an object is compatible with a desired manufacturing process, such as injection molding.

The verification method, specifically in step IV of the method, comprises using the simulation method as described above or as described in further detail below. Thus, for possible definitions of most of the terms used herein, reference may be made to the description of the simulation method as disclosed in the first aspect of the present invention.

In step III, the at least one plastic material and the at least one injection point may be chosen automatically, for example by an algorithm. Alternatively however the at least one plastic material may be chosen by at least one user, specifically by a user using the verification method.

The simulation result evaluated in step V. may for example be at least one visualization and may be output via at least one interface or port.

In a further aspect of the invention, a computer system is disclosed. The computer system comprises at least one processor configured to perform the computer implemented method for simulating a filling process, e.g. the simulation method, as described above or as described in further detail below.

The term "processor" as used herein is a broad term and is to be given its ordinary and customary meaning to a person of ordinary skill in the art and is not to be limited to a special or customized meaning. The term specifically may refer, without limitation, to an arbitrary logic circuitry configured for performing basic operations of a computer or system. In particular, the processor may be configured for processing basic instructions that drive the computer or system. As an example, the processor may comprise at least one arithmetic logic unit (ALU), at least one floating-point unit (FPU), such as a math coprocessor or a numeric coprocessor, a plurality of registers, specifically registers configured for supplying operands to the ALU and storing results of operations, and a memory, such as an L1 and L2 cache memory. In particular, the processor may be a multi-core processor. Specifically, the processor may be or may comprise a central processing unit (CPU). Additionally or alternatively, the processor may be or may comprise a microprocessor, thus specifically the processor's elements may be contained in one single integrated circuitry (IC) chip.

As an example, the computer system may further comprise at least one or both of a data storage or memory for storing a database. In particular, the computer system may comprise a data storage and/or a memory for storing the database as described above.

In particular, the data storage or memory may be selected from the group consisting of: an internal data storage, e.g. an internal drive or memory; an external data storage, e.g. an external drive, an external data server, such as a cloud server; a portable memory, such as a memory stick or a portable drive.

Further, the computer system may comprise at least one interface or port. As an example, the interface or port may be configured for one or more of: receiving information related to the injection molding process, wherein the information relates to one or both of a mold cavity shape and a plastic material to be used; and outputting information related to the simulation result, specifically outputting at least one visualization.

Specifically, the at least one interface or port may be selected from the group consisting of: a network or internet port, a USB-port, e.g. for entering information via a computer mouse or keyboard; a disk drive.

In a further aspect of the invention, a computer program is disclosed. The computer program comprises instructions which, when the program is executed by a computer or computer system, cause the computer or computer system to carry out the simulation method as described above or as described in further detail below. In particular, one, more than one or even all of the method steps i) to v) of the simulation method as indicated above may be performed by using a computer or computer network, preferably by using the computer program. Thus, for possible definitions of most of the terms used herein, reference may be made to the description of the simulation method as disclosed in the first aspect of the present invention.

In a further aspect of the invention, a verification computer program is disclosed. The verification computer program comprises instructions which, when the program is executed by a computer or computer system, cause the computer or computer system to carry out at least steps II, IV and V of the verification method as described above or as described in further detail below. Thus, specifically for causing the computer or computer system to carry out step IV the verification method, the verification computer program comprises the computer program as described above or as described in further detail below.

Specifically, one or both of the computer program and the verification computer program may be stored on a computer-readable data carrier and/or on a computer-readable storage medium. As used herein, the terms "computer-readable data carrier" and "computer-readable storage medium" specifically may refer to non-transitory data storage means, such as a hardware storage medium having stored thereon computer-executable instructions. The computer-readable data carrier or storage medium specifically may be or may comprise a storage medium such as a random-access memory (RAM) and/or a read-only memory (ROM).

Further disclosed and proposed herein is a computer program product having program code means, in order to perform one or both of the simulation method and the verification method according to the present invention in one or more of the embodiments enclosed herein when the program is executed on a computer or computer network. Specifically, the program code means may be stored on a computer-readable data carrier and/or computer-readable storage medium.

Further disclosed and proposed herein is a data carrier having a data structure stored thereon, which, after loading into a computer or computer network, such as into a working memory or main memory of the computer or computer network, may execute one or both of the simulation method and the verification method according to one or more of the embodiments disclosed herein.

Further disclosed and proposed herein is a computer program product with program code means stored on a machine-readable carrier, in order to perform one or both of the simulation method and the verification method according to one or more of the embodiments disclosed herein, when the program is executed on a computer or computer network. As used herein, a computer program product refers to the program as a tradable product. The product may generally exist in an arbitrary format, such as in a paper format, or on a computer-readable data carrier. Specifically, the computer program product may be distributed over a data network.

In a further aspect of the invention, a database for use in the simulation method is disclosed. The database contains information on a fiber orientation for a fiber-reinforced plastic material for at least one dummy element. Specifically, the database may be database as provided in step vi.1) of the simulation method. Thus, for possible definitions of most of the terms used herein, reference may be made to the description of the simulation method as disclosed in the first aspect of the present invention.

The methods, systems, programs and databases of the present invention have numerous advantages over methods, systems, programs and databases known in the art. In particular, the methods, systems, programs and databases as disclosed herein may improve the performance of simulating a filling process of a mold cavity in an injection molding process, compared to devices, methods and systems known in the art. Specifically, a processing time, e.g. a run time, may be significantly reduced by the present invention. Further, the present invention may require less computation capacity and less memory requirements than state-of-the-art injection molding process simulation methods. It also requires less effort for preparing the simulation model.

In particular, assigning a cell coordinate system, as determined in step iv) of the computer-implemented method for simulating a filling process of a mold cavity in an injection molding process using a plastic material, to each of the cells may significantly reduce calculation time. In particular, the cell coordinate system determined for each cell may significantly reduce a time necessary for determining the fiber orientation tensor as it can be.

Summarizing and without excluding further possible embodiments, the scope of the invention is defined by the appended claims.

Short description of the Figures

Further optional features and embodiments will be disclosed in more detail in the subsequent description of embodiments, preferably in conjunction with the dependent claims. Therein, the respective optional features may be realized in an isolated fashion as well as in any arbitrary feasible combination, as the skilled person will realize. The scope of the invention is not restricted by the preferred embodiments. The embodiments are schematically depicted in the Figures. Therein, identical reference numbers in these Figures refer to identical or functionally comparable elements.

In the Figures:

| | |
|---|---|
| Figure 1 | shows an embodiment of CAD data of an object and a corresponding embodiment of a mold cavity for injection molding the object in a perspective view; |
| Figure 2 | shows a section view of part of the embodiment of CAD data of the object and the corresponding embodiment of the mold cavity as illustrated in Figure 1; |
| Figures 3 and 4 | show different embodiments of mold cavities in a perspective view; |
| Figure 5 | shows an embodiment of a database in a perspective view; |
| Figure 6 | shows an embodiment of a computer system in a perspective view; |
| Figures 7A and 7B | show flow charts of different embodiments of a simulation method; |
| Figure 8 | shows a flow chart of an embodiment of a verification method; |
| Figure 9 | shows a section view of an embodiment of a mold cavity in an injection molding process using a plastic material; |
| Figure 10 | shows a part of an embodiment of a discretized mold cavity in an injection molding process using a plastic material in a top plane view; and |
| Figure 11 | shows a filling process of an embodiment of a mold cavity in an injection molding process using a plastic material in a perspective view. |

Detailed description of the embodiments

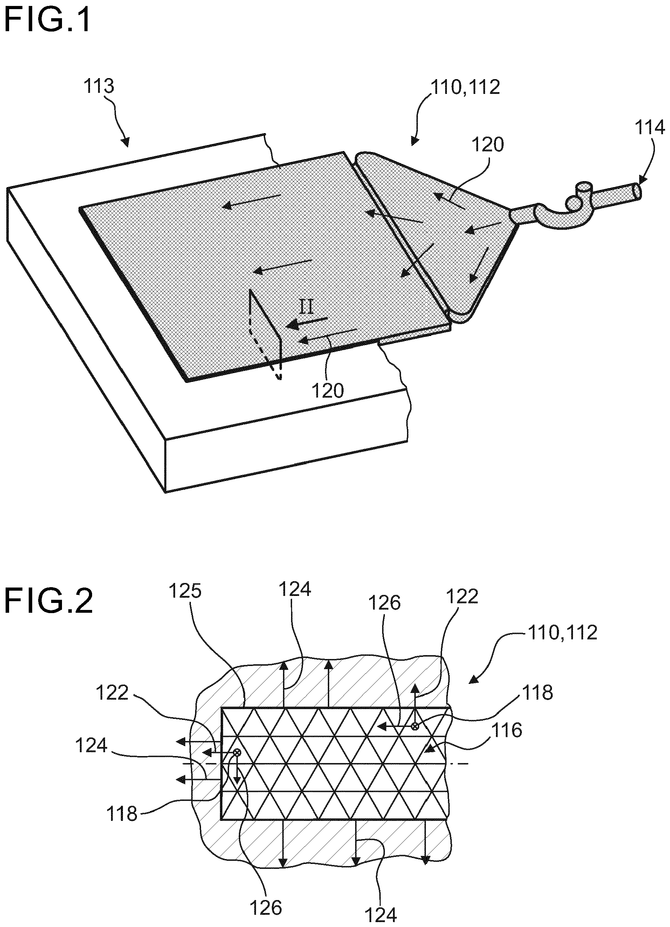

In Figure 1 an embodiment of CAD data of an object 110 and a corresponding embodiment of a mold cavity 112 for injection molding the object is illustrated in a perspective view. For illustrational purposes a die 113 having a void in the shape of the mold cavity 112 is partly illustrated. A cavity injection point 114 may be defined on the mold cavity 112. Figure 2 shows a section view of part of the mold cavity 112 as illustrated in Figure 1. The mold cavity 112 may be discretized into a plurality of cells 116. Each cell 116 may comprise a cell coordinate system. The cell coordinate system may be defined by a first principal direction 118 parallel to a flow direction 120, as exemplarily illustrated in Figure 1. Further, the cell coordinate system may be defined by a third principal direction 122 parallel to a surface normal direction 124, as exemplarily illustrated in Figure 2, wherein the surface normal direction 124 may be oriented in a perpendicular fashion to the nearest cavity surface 125. Lastly, the cell coordinate system may be defined by a second principal direction 126 perpendicular to the first principal direction 118 and the third principal direction 122.

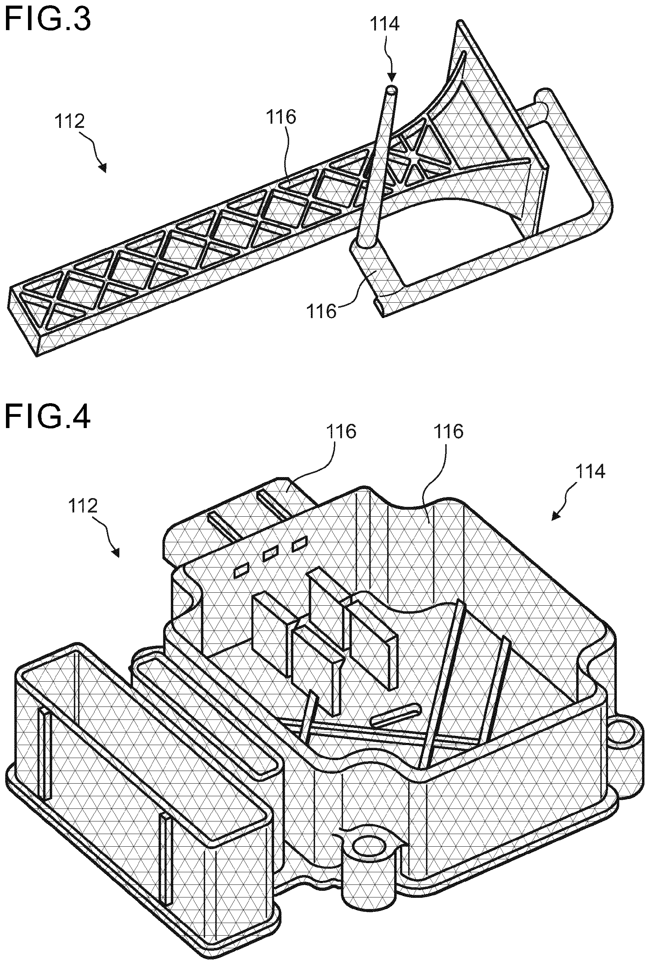

In the Figures 3 and 4 different embodiments of mold cavities 112 are illustrated with cavity injection points 114. In particular, each mold cavity 112 may be discretized into a plurality of cells 116.

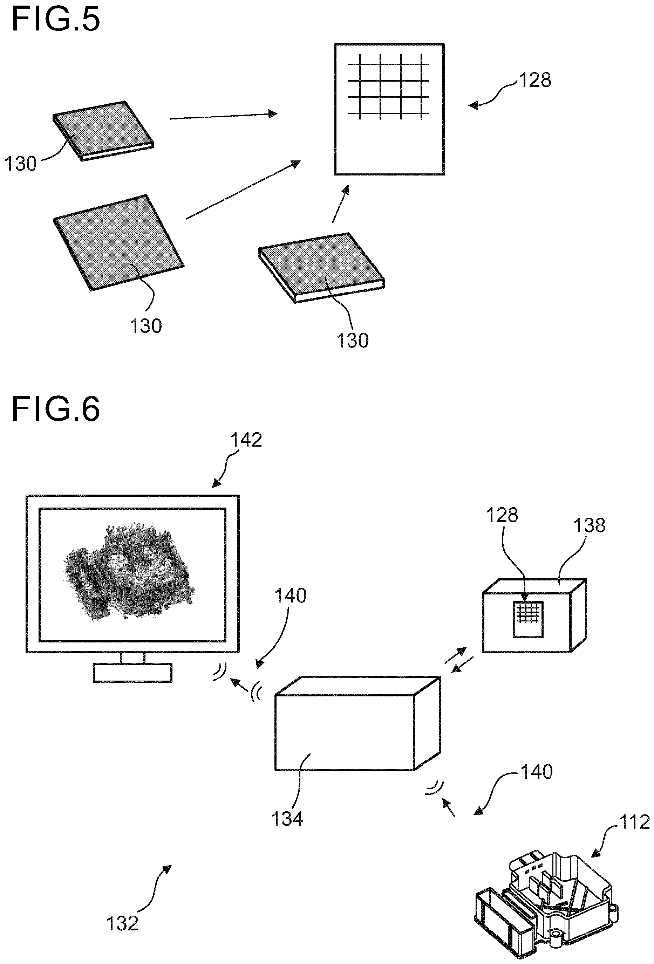

In Figure 5 an embodiment of a database 128 is illustrated. The database 128 comprises information on a fiber orientation for a fiber-reinforced plastic material for at least one dummy element 130. Specifically, as illustrated in Figure 5, the database 128 may comprise information on the fiber orientation for the fiber-reinforced plastic material for more than one, for example three dummy elements 130. In particular, the information contained in the database 128 may comprise one or both of simulated data or empirically retrieved data on fiber orientation, specifically for a fiber-reinforced plastic material for the dummy elements 130.

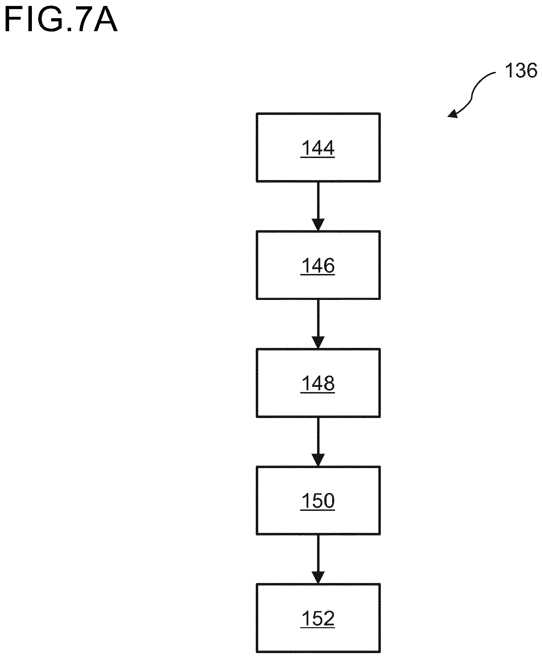

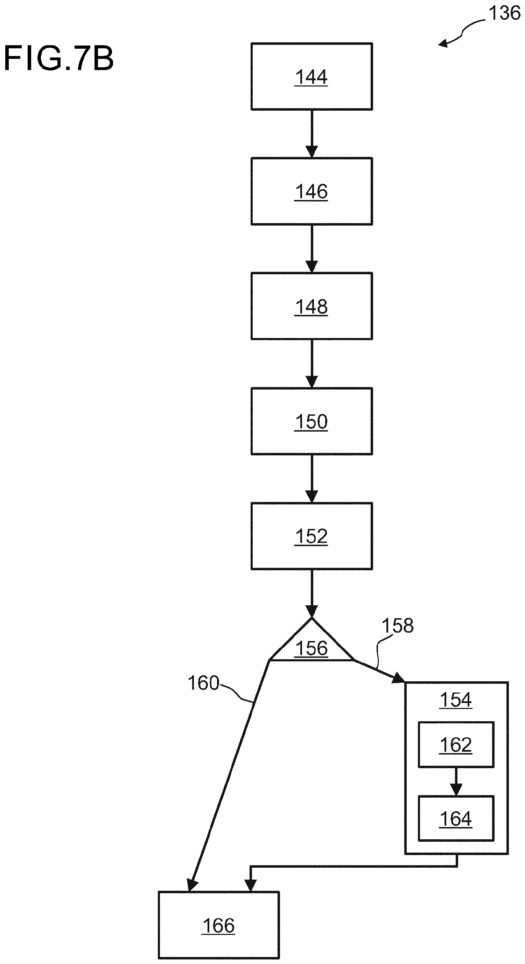

Figure 6 illustrates an embodiment of a computer system 132 and a perspective view. The computer system 132 comprises at least one processor 134 configured for performing a computer-implemented method for simulating a filling process, e.g. a simulation method 136. Flow charts of different embodiments of the computer-implemented method 136 for simulating a filling process, in particular of the simulation method 136, are illustrated in Figures 7A and 7B. The computer system 132 may comprise a data storage 138, for example for storing the database 128. Further, the computer system 132 may comprise at least one interface 140. The interface 140 may be configured for receiving information relating to a shape of the mold cavity 112. Additionally or alternatively, the interface 140 may be configured for outputting information related to a simulation result, such as a visualization 142.

The computer-implemented method 136 for simulating a filling process of a mold cavity 112 in an injection molding process using a plastic material, specifically the simulation method 136, comprises the following steps, which may specifically be performed in the given order. Still, a different order may also be possible. It may be possible to perform two or more of the method steps fully or partially simultaneously. It may further be possible to perform one, more than one or even all of the method steps once or repeatedly. The method may comprise additional method steps which are not listed herein. The method steps of the simulation method 136 are the following:

step i) (denoted with reference number 144) discretizing at least a part of the mold cavity 112 into a plurality of cells 116;

step ii) (denoted with reference number 146) defining a cavity injection point 114;

step iii) (denoted with reference number 148) determining a surface normal direction 124 perpendicular to the nearest cavity surface 125 for each cell 116;

step iv) (denoted with reference number 150) determining a cell coordinate system for each cell 116, defined by
- a first principal direction 118 parallel to a flow direction 120,
- a third principal direction 122 parallel to the normal direction 124, and
- a second principal direction 126 perpendicular to the first 118 and third 122 principal directions; and

step v) (denoted with reference number 152) determining the flow direction 120 of a mold flow for each cell 116.

Further, the simulation method 136, in case the plastic material is a fiber-reinforced plastic material, may comprise step vi) (denoted with reference number 154) comprising determining fiber orientation of the fiber-reinforced plastic material.

As illustrated in Figure 7B, an embodiment of the simulation method 136 may additionally comprise a branching point 156. The branching point 156 may indicate a condition query, such as deciding between a first branch 158 and a second branch 160. For example, the condition query may make use of information on the plastic material, such as information on whether the plastic material is a fiber-reinforced plastic material or not. The first branch 158 may indicate the plastic material to be or to comprise a fiber-reinforced plastic material, thus the first branch may lead to step vi) 154. The second branch 160 may indicate the plastic material not to comprise a fiber-reinforced plastic material.

Step vi) 154 may specifically comprise substep vi.1) (denoted with reference number 162) providing a database 128, the database 128 containing information on fiber orientation for the fiber-reinforced plastic material for at least one dummy element 130. Step vi) 154 may further comprise substep vi.2) (denoted with reference number 164) retrieving information on fiber orientation for each cell 116 from the database 128 by using a cell position of the cell 116 and determining fiber orientation for the cell 116 in the cell coordinate system.

In particular, substep vi1) 164 may be performed by using similarity considerations between the mold cavity 112 and the dummy element 130. Specifically, substep vi.2) 164 may be performed by using similarity considerations between a shape of the mold cavity 112 and a shape of the dummy element 130.

The simulation method 136, may further comprise step step vii) (denoted with reference number 166) outputting at least one visualization 142, wherein the visualization 142 may be selected from the group consisting of: a fiber orientation, specifically a direction of fiber orientation; a degree of fiber orientation, specifically a degree of fiber orientation in at least one principal direction; a filling state, specifically a filling state after a predetermined amount of time; a pressure state, specifically a pressure state after a predetermined amount of time; a shear rate distribution, specifically a shear rate distribution state after a predetermined amount of time; a mass accumulations state; a flow path length state; a shrinkage state.

In particular, step vii) 166 may be performed after performing step vi). Alternatively, in case the plastic material does not comprise a fiber-reinforced plastic material, step vi) 154 of the simulation method 136 may be skipped. Thus, as an example, step vii) 166 may be performed directly after performing step v) 152, as illustrated in Figure 7B by the second branch 160 directly leading to step vii) 166 of the simulation method 136.

Specifically, performing the simulation method 136 may take a processing time T, e.g. a run time. As an example, in table 1 a run time comparison for performing a filling simulation of three different mold cavities 112 may be illustrated. In particular, the run time $T_{State\_of\_the\_art}$ necessary for performing the filling simulation by using an injection molding process simulation method as known to the skilled person, such as by using FEM simulations, may be compared to the run time $T_{sim}$ necessary for performing the simulation method 136 as proposed herein. Specifically, the run time comparison illustrated in table 1 may show the run times $T_{State\_of\_the\_art}$ in the second column and $T_{sim}$ in the third column of the table 1. The run times may be compared for three different mold cavities 112, in particular for the three different embodiments of the mold cavity 112 as illustrated in Figure 1, Figure 3 and Figure 4. The mesh size being used for performing the filling simulations may be 2.0 mm for all three mold cavities 112. In the fourth column of the table 1 a performance gain may be listed, wherein the performance gain may indicate the absolute number of times the simulation method 136 may be performed within the run time $T_{State\_of\_the\_art}$ necessary for once performing the filling simulation by using an injection molding process simulation method as known to the skilled person.

*Table 1: Comparison of run times of FEM simulations ($T_{State\_of\_the\_art}$) vs. simulations according to the present invention ($T_{sim}$), for various objects.*

| mold cavity | $T_{State\_of\_the\_art}$ | $T_{sim}$ | performance gain |
|---|---|---|---|
| "P11 Plaque" (illustrated in Figure 1) | 78 min | 15s | 312 x |
| "Eiffel tower test part" (illustrated in Figure 3) | 160 min | 27 s | 355 x |
| "ECU Housing" (illustrated in Figure 4) | 130 min | 20 s | 390 x |

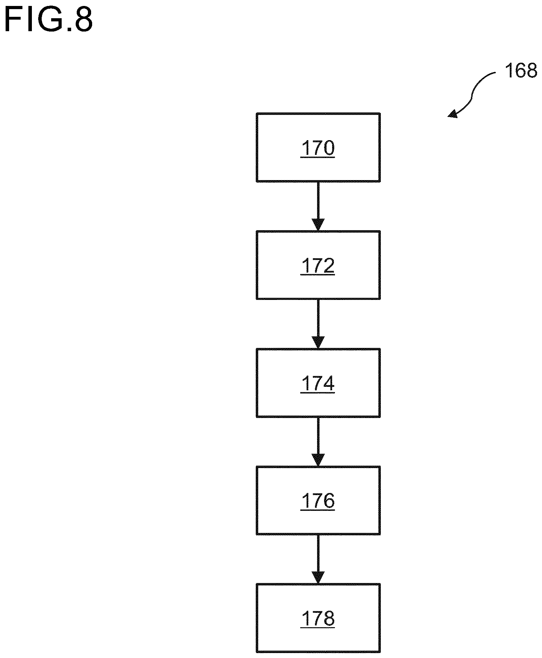

In Figure 8 a flow chart of an embodiment of a method for verifying a design of an object 110, specifically of a verification method 168, is shown. The verification method 168 comprises the following steps, which may specifically be performed in the given order. Still, a different order may also be possible. It may be possible to perform two or more of the method steps fully or partially simultaneously. It may further be possible to perform one, more than one or even all of the method steps once or repeatedly. The method may comprise additional method steps which are not listed herein. The method steps of the verification method 168 are the following:

step I.   (denoted with reference number 170) providing CAD data of the object 110;
step II.   (denoted with reference number 172) transforming the CAD data of the object 110 into CAD data of a corresponding mold cavity 112 for injection molding the object 110;
step III.   (denoted with reference number 174) choosing at least one plastic material and at least one injection point 114;
step IV.   (denoted with reference number 176) simulating a filling process of the mold cavity 112 by using the simulation method 136; and
step V.   (denoted with reference number 178) evaluating a simulation result provided by step IV 176.

In particular, the simulation result evaluated in step V. may be at least one visualization 142 output via at least one interface140, as for example illustrated in Figure 6.

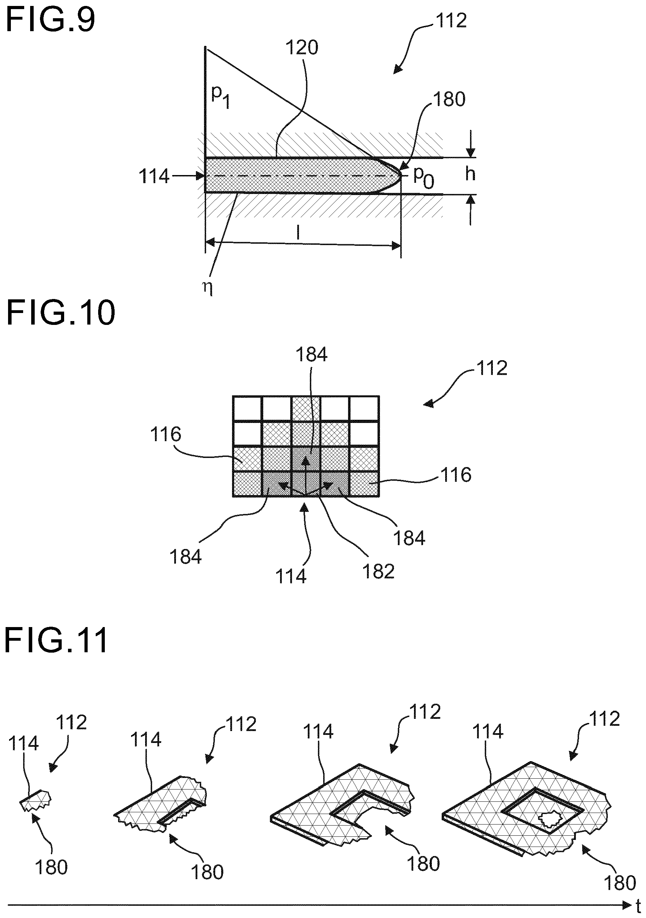

In Figure 9 a section view of an embodiment of a mold cavity 112 in an injection molding process using a plastic material is illustrated. In particular, Figure 9 may show a visual derivation of formula (1), e.g. of a physical equation, as described above, specifying a link between a velocity v of a flow front 180 of a molten mass of the plastic material and a thickness h, a viscosity $\eta$ of the molten mass of the plastic material, a filling pressure $p_1$, an ambient pressure $p_0$ and a distance I from the flow front 180 to a cavity injection point 114.

In Figure 10 a part of an embodiment of a discretized mold cavity 112 in an injection molding process using a plastic material is illustrated. In particular, Figure 10 may show a topological approach of the filling process, specifically of a molten mass of the plastic material filling the mold cavity 112 starting at a cavity injection point 114 and spreading from one cell 116, specifically from a starting cell 182, to its neighboring cells 184 as indicated by arrows within Figure 9.

In Figure 11 a filling process of an embodiment of a mold cavity 112 in an injection molding process using a plastic material is illustrated in a perspective view. In particular, four fill stages of the mold cavity 112 in the injection molding process are shown, wherein the fill stages advance from left to right, as indicated by an x-axis at the bottom of Figure 11 indicating an advance of time t. In particular, a flow front 180 may advance within the mold cavity 112 according to a mix of a topological approach and a physical approach.

List of reference numbers

[0108]

110   object
112   mold cavity
113   die
114   cavity injection point
116   cell
118   first principal direction

120 flow direction
122 third principal direction
124 normal direction
125 cavity surface
126 second principal direction
128 database
130 dummy element
132 computer system
134 processor
136 simulation method
138 data storage
140 interface
142 visualization
144 step i)
146 step ii)
148 step iii)
150 step iv)
152 step v)
154 step vi)
156 branching point
158 first branch
160 second branch
162 step vi.1)
164 step vi.2)
166 step vii)
168 verification method
170 step I.
172 step II.
174 step III.
176 step IV.
178 step V.
180 flow front
182 starting cell
184 neighboring cell

**Claims**

1. A computer-implemented method for simulating a filling process of a mold cavity (112) in an injection molding process using a plastic material, the method comprising:

   i) discretizing at least a part of the mold cavity (112) into a plurality of cells (116);
   ii) defining a cavity injection point (114);
   iii) determining a surface normal direction (124) perpendicular to the nearest cavity surface (125) for each cell (116);
   iv) determining a cell coordinate system for each cell (116), defined by

   - a first principal direction (118) parallel to a flow direction (120),
   - a third principal direction (122) parallel to the normal direction (124), and
   - a second principal direction (126) perpendicular to the first (118) and third (122) principal directions; and

   v) determining the flow direction (120) of a mold flow for each cell (116).

2. The method according to the preceding claim, wherein, if the plastic material is a fiber-reinforced plastic material, the method further comprises:
   vi) determining fiber orientation of the fiber-reinforced plastic material.

3. The method according to the preceding claim, wherein step vi) comprises:

vi.1) providing a database (128), the database (128) containing information on fiber orientation for the fiber-reinforced plastic material for at least one dummy element (130).

4. The method according to the preceding claim, wherein the information contained in the database (128) comprises one or both of simulated data or empirically retrieved data on fiber orientation.

5. The method according to any one of the two preceding claims, wherein step vi) further comprises:
vi.2) retrieving information on fiber orientation for each cell (116) from the database (128) by using a cell position of the cell (116) and determining fiber orientation for the cell (116) in the cell coordinate system.

6. The method according to any one of the preceding claim, wherein step vi.2) is performed by using similarity considerations between the mold cavity (112) and the dummy element (130).

7. The method according to the preceding claim, wherein the similarity considerations are based on the assumption that, by using similar definitions of coordinate systems for the cell (116) of the mold cavity (112) and for the dummy element (130), the fiber orientation in the mold cavity (112) is identical to the fiber orientation in the dummy element (130) for identical relative positions within the mold cavity (112) and the dummy element (130), respectively.

8. The method according to any one of the preceding claims, wherein the method further comprises determining neighboring cells (184) for each individual cell (116) of the plurality of cells.

9. The method according to the preceding claim, wherein the method further comprises determining a cell-filling sequence using information on the neighboring cells (184).

10. The method according to the preceding claim, wherein the method comprises a recursive determination of an inflow of a molten mass of the plastic material from neighboring cells (184) for each individual cell (116).

11. The method according to the preceding claim, wherein the method comprises recursively solving a continuity equation for each individual cell (116) by considering inflow from neighboring cells (184) and outflow into neighboring cells (184).

12. The method according to any one of the nine preceding claims, wherein the database (128) contains information on fiber orientation for a plurality of fiber-reinforced plastic materials.

13. The method according to any one of the preceding claims, wherein the method further comprises determining a wall thickness information for each of the cells of the plurality of cells, specifically before performing step v), more specifically between steps iv) and v)

14. The method according to any one of the preceding embodiments, wherein performing at least steps i) to v) of the method takes a processing time T, wherein 0 s < T ≤ 300 s, specifically 0 s < T ≤ 120 s, more specifically 0 s < T ≤ 60 s, particularly 0 s < T ≤ 30 s.

15. The method according to any one of the preceding claims, wherein the method further comprises:
vii) outputting at least one visualization (142), wherein the visualization (142) is output via at least one interface (140) or port.

16. A method for verifying a design of an object (110), the method comprising:

   I. providing CAD data of the object (110);
   II. transforming the CAD data of the object (110) into CAD data of a corresponding mold cavity (112) for injection molding the object (110);
   III. choosing at least one plastic material and at least one injection point (114);
   IV. simulating a filling process of the mold cavity (112) by using the method according to any one of the preceding claims; and
   V. evaluating a simulation result provided by step IV.

17. The method according to the preceding claim, wherein the simulation result evaluated in step V. is at least one visualization (142) output via at least one interface (140) or port.

**18.** A computer system (132) comprising at least one processor (134) configured to perform the computer implemented method for simulating a filling process according to any one of claims 1 to 15.

**19.** A computer program comprising instructions which, when the program is executed by a computer or computer system (132), cause the computer or computer system (132) to carry out the method according to any one of claims 1 to 15.

**Patentansprüche**

**1.** Computerimplementiertes Verfahren zum Simulieren eines Füllprozesses eines Formhohlraums (112) in einem Spritzgießprozess unter Verwendung eines Kunststoffmaterials, wobei das Verfahren umfasst:

i) Diskretisieren von mindestens einem Teil des Formhohlraums (112) in eine Vielzahl von Zellen (116);
ii) Definieren eines Hohlraumanspritzpunkts (114);
iii) Bestimmen einer Richtung der Flächennormalen (124) senkrecht zu der nächstgelegenen Hohlraumoberfläche (125) für jede Zelle (116);
iv) Bestimmen eines Zellkoordinatensystems für jede Zelle (116), definiert durch

- eine erste Hauptrichtung (118) parallel zu der Flussrichtung (120),
- eine dritte Hauptrichtung (122) parallel zu der Normalrichtung (124), und
- eine zweite Hauptrichtung (126) senkrecht zu der ersten (118) und der dritten (122) Hauptrichtung; und

v) Bestimmen der Flussrichtung (120) eines Formflusses für jede Zelle (116).

**2.** Verfahren nach dem vorhergehenden Anspruch, wobei das Verfahren, falls das Kunststoffmaterial ein faserverstärktes Kunststoffmaterial ist, des Weiteren umfasst:
vi) Bestimmen der Faserorientierung des faserverstärkten Kunststoffmaterials.

**3.** Verfahren nach dem vorhergehenden Anspruch, wobei Schritt vi) umfasst:
vi. 1) Bereitstellen einer Datenbank (128), wobei die Datenbank (128) Informationen zur Faserorientierung für das faserverstärkte Kunststoffmaterial für mindestens ein Anfahrelement (130) enthält.

**4.** Verfahren nach dem vorhergehenden Anspruch, wobei die in der Datenbank (128) enthaltenen Informationen ein oder beide von simulierten Daten oder empirisch abgerufenen Daten zur Faserorientierung umfassen.

**5.** Verfahren nach einem der beiden vorhergehenden Ansprüche, wobei Schritt vi) des Weiteren umfasst:
vi.2) Abrufen von Informationen zur Faserorientierung für jede Zelle (116) aus der Datenbank (128) unter Verwendung einer Zellposition der Zelle (116), und Bestimmen der Faserorientierung für die Zelle (116) in dem Zellkoordinatensystem.

**6.** Verfahren nach einem der vorhergehenden Ansprüche, wobei Schritt vi.2) unter Verwendung von ähnlichen Betrachtungen zwischen dem Formhohlraum (112) und dem Anfahrelement (130) durchgeführt wird.

**7.** Verfahren nach dem vorhergehenden Anspruch, wobei die Ähnlichkeitsbetrachtungen auf der Annahme basieren, dass unter Verwendung von ähnlichen Definitionen der Koordinatensysteme für die Zelle (116) des Formhohlraums (112) und für das Anfahrelement (130) die Faserorientierung in dem Formhohlraum (112) identisch mit der Faserorientierung in dem Anfahrelement (130) für identische relative Positionen innerhalb des Formhohlraums (112) und des Anfahrelements (130) ist.

**8.** Verfahren nach einem der vorhergehenden Ansprüche, wobei das Verfahren des Weiteren das Bestimmen von benachbarten Zellen (184) für jede individuelle Zelle (116) der Vielzahl von Zellen umfasst.

**9.** Verfahren nach dem vorhergehenden Anspruch, wobei das Verfahren des Weiteren Bestimmen einer Zellfüllabfolge unter Verwendung von Informationen zu den benachbarten Zellen (184) umfasst.

**10.** Verfahren nach dem vorhergehenden Anspruch, wobei das Verfahren eine rekursive Bestimmung eines Einfließens einer geschmolzenen Masse aus dem Kunststoffmaterial aus benachbarten Zellen (184) für jede individuelle Zelle

16

(116) umfasst.

11. Verfahren nach dem vorhergehenden Anspruch, wobei das Verfahren rekursives Lösen einer Kontinuitätsgleichung für jede individuelle Zelle (116) durch Betrachten des Einfließens aus benachbarten Zellen (184) und des Ausfließens in benachbarte Zellen (184) umfasst.

12. Verfahren nach einem der neun vorhergehenden Ansprüche, wobei die Datenbank (128) Informationen zur Faserorientierung für eine Vielzahl von faserverstärkten Kunststoffmaterialien enthält.

13. Verfahren nach einem der vorhergehenden Ansprüche, wobei das Verfahren des Weiteren Bestimmen von Wanddickeninformationen für jede der Zellen von der Vielzahl der Zellen umfasst, speziell vor dem Durchführen von Schritt v), insbesondere zwischen den Schritten iv) und v).

14. Verfahren nach einem der vorhergehenden Ansprüche, wobei Durchführen von mindestens den Schritten i) bis v) des Verfahrens eine Verarbeitungszeit T benötigt, wobei 0 s < T ≤ 300 s, speziell 0 s < T ≤ 120 s, insbesondere 0 s < T ≤ 60 s, besonders 0 s < T ≤ 30 s.

15. Verfahren nach einem der vorhergehenden Ansprüche, wobei das Verfahren des Weiteren umfasst: vii) Ausgeben von mindestens einer Visualisierung (142), wobei die Visualisierung (142) mittels mindestens einer Schnittstelle (140) oder eines Ports ausgegeben wird.

16. Verfahren zum Verifizieren eines Designs eines Objekts (110), wobei das Verfahren umfasst:

   i. Bereitstellen von CAD-Daten des Objekts (110);
   ii. Umwandeln der CAD-Daten des Objekts (110) in CAD-Daten eines entsprechenden Formhohlraums (112) zum Spritzgießen des Objekts (110);
   iii. Auswählen von mindestens einem Kunststoffmaterial und mindestens einem Anspritzpunkt (114);
   iv. Simulieren eines Füllprozesses des Formhohlraums (112) durch Verwenden des Verfahrens nach einem der vorhergehenden Ansprüche; und
   v. Auswerten eines durch Schritt IV bereitgestellten Simulationsergebnisses.

17. Verfahren nach dem vorhergehenden Anspruch, wobei das in Schritt v. ausgewertete Simulationsergebnis mindestens eine Visualisierung (142) ist, die mittels mindestens einer Schnittstelle (140) oder eines Ports ausgegeben wird.

18. Computersystem (132), umfassend mindestens einen Prozessor (134), der ausgestaltet ist, um das computerimplementierte Verfahren zum Simulieren eines Füllprozesses gemäß einem der Ansprüche 1 bis 15 durchzuführen.

19. Computerprogramm, umfassend Anweisungen, die bei Ausführung des Programms durch einen Computer oder ein Computersystem (132) bewirken, dass der Computer oder das Computersystem (132) das Verfahren gemäß einem der Ansprüche 1 bis 15 durchführt.


**Revendications**

1. Procédé mis en œuvre par ordinateur pour simuler un processus de remplissage d'une cavité de moule (112) dans un processus de moulage par injection utilisant une matière plastique, le procédé comprenant :

   i) la discrétisation d'au moins une partie de la cavité de moule (112) en une pluralité de cellules (116) ;
   ii) la définition d'un point d'injection de cavité (114) ;
   iii) la détermination d'une direction normale de surface (124) perpendiculaire à la surface de cavité la plus proche (125) pour chaque cellule (116) ;
   iv) la détermination d'un système de coordonnées cellulaires pour chaque cellule (116), défini par

      - une première direction principale (118) parallèle à une direction d'écoulement (120),
      - une troisième direction principale (122) parallèle à la direction normale (124), et
      - une deuxième direction principale (126) perpendiculaire aux première (118) et troisième (122) directions principales ; et

v) la détermination de la direction de flux (120) d'un flux de moule pour chaque cellule (116).

2. Procédé selon la revendication précédente, dans lequel, si la matière plastique est une matière plastique renforcée par des fibres, le procédé comprend en outre :
   v) la détermination de l'orientation des fibres de la matière plastique renforcée par des fibres.

3. Procédé selon la revendication précédente, dans lequel l'étape vi) comprend :
   vi.1) la fourniture d'une base de données (128), la base de données (128) contenant des informations sur l'orientation des fibres de la matière plastique renforcée par des fibres pour au moins un élément factice (130).

4. Procédé selon la revendication précédente, dans lequel les informations contenues dans la base de données (128) comprennent des données simulées et/ou des données récupérées empiriquement sur l'orientation des fibres.

5. Procédé selon l'une quelconque des deux revendications précédentes, dans lequel l'étape vi) comprend en outre :
   vi.2) la récupération d'informations sur l'orientation des fibres pour chaque cellule (116) de la base de données (128) en utilisant une position cellulaire de la cellule (116) et la détermination de l'orientation des fibres pour la cellule (116) dans le système de coordonnées cellulaires.

6. Procédé selon l'une quelconque des revendications précédentes, dans lequel l'étape vi.2) est réalisée en utilisant des considérations de similarité entre la cavité de moule (112) et l'élément factice (130).

7. Procédé selon la revendication précédente, dans lequel les considérations de similarité sont basées sur l'hypothèse que, en utilisant des définitions similaires de systèmes de coordonnées pour la cellule (116) de la cavité de moule (112) et pour l'élément factice (130), l'orientation des fibres dans la cavité de moule (112) est identique à l'orientation des fibres dans l'élément factice (130) pour des positions relatives identiques à l'intérieur de la cavité de moule (112) et de l'élément factice (130), respectivement.

8. Procédé selon l'une quelconque des revendications précédentes, dans lequel le procédé comprend en outre la détermination de cellules voisines (184) pour chaque cellule individuelle (116) de la pluralité de cellules.

9. Procédé selon la revendication précédente, dans lequel le procédé comprend en outre la détermination d'une séquence de remplissage de cellules en utilisant des informations sur les cellules voisines (184).

10. Procédé selon la revendication précédente, dans lequel le procédé comprend une détermination récursive d'un afflux d'une masse fondue de la matière plastique à partir des cellules voisines (184) pour chaque cellule individuelle (116).

11. Procédé selon la revendication précédente, dans lequel le procédé comprend la résolution récursive d'une équation de continuité pour chaque cellule individuelle (116) en tenant compte de l'afflux à partir des cellules voisines (184) et de l'écoulement dans les cellules voisines (184).

12. Procédé selon l'une quelconque des neuf revendications précédentes, dans lequel la base de données (128) contient des informations sur l'orientation des fibres pour une pluralité de matières plastiques renforcées par des fibres.

13. Procédé selon l'une quelconque des revendications précédentes, dans lequel le procédé comprend en outre la détermination d'une information d'épaisseur de paroi pour chacune des cellules de la pluralité de cellules, précisément avant d'effectuer l'étape v), plus précisément entre les étapes iv) et v).

14. Procédé selon l'un quelconque des modes de réalisation précédents, dans lequel la réalisation d'au moins les étapes i) à v) du procédé prend un temps de traitement T, dans lequel $0 \text{ s} < T \leq 300 \text{ s}$, précisément $0 \text{ s} < T \leq 120$ s, plus précisément $0 \text{ s} < T \leq 60 \text{ s}$, particulièrement $0 \text{ s} < T \leq 30 \text{ s}$.

15. Procédé selon l'une quelconque des revendications précédentes, dans lequel le procédé comprend en outre :
    vii) la sortie d'au moins une visualisation (142), dans lequel la visualisation (142) est sortie par le biais d'au moins une interface (140) ou un port.

16. Procédé de vérification de la conception d'un objet (110), le procédé comprenant :

I. la fourniture de données de CAO de l'objet (110) ;

II. la transformation des données de CAO de l'objet (110) en données de CAO d'une cavité de moule correspondante (112) pour le moulage par injection de l'objet (110) ;

III. le choix d'au moins une matière plastique et d'au moins un point d'injection (114) ;

IV. la simulation d'un processus de remplissage de la cavité de moule (112) en utilisant le procédé selon l'une quelconque des revendications précédentes ; et

V. l'évaluation d'un résultat de simulation fourni par l'étape IV.

17. Procédé selon la revendication précédente, dans lequel le résultat de simulation évalué à l'étape V. est au moins une visualisation (142) sortie par le biais d'au moins une interface (140) ou un port.

18. Système informatique (132) comprenant au moins un processeur (134) configuré pour exécuter le procédé mis en œuvre par ordinateur pour simuler un processus de remplissage selon l'une quelconque des revendications 1 à 15.

19. Programme d'ordinateur comprenant des instructions qui, lorsque le programme est exécuté par un ordinateur ou un système informatique (132), amènent l'ordinateur ou le système informatique (132) à mettre en œuvre le procédé selon l'une quelconque des revendications 1 à 15.

# FIG.1

# FIG.2

FIG.3

FIG.4

FIG.5

FIG.6

# FIG.7A

136

```
┌─────────┐
│   144   │
└─────────┘
     │
     ▼
┌─────────┐
│   146   │
└─────────┘
     │
     ▼
┌─────────┐
│   148   │
└─────────┘
     │
     ▼
┌─────────┐
│   150   │
└─────────┘
     │
     ▼
┌─────────┐
│   152   │
└─────────┘
```

FIG.7B

136

144

146

148

150

152

156

158

160

154

162

164

166

# FIG.8

168

# FIG.9

# FIG.10

# FIG.11

**EP 4 003 688 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2612266 B1
- EP 1376415 A2
- US 9919465 B1
- US 2008221845 A1
- US 9862133 B1